(19) Europäisches Patentamt / European Patent Office / Office européen des brevets

(11) **EP 4 349 782 A1**

(12) **EUROPEAN PATENT APPLICATION**
published in accordance with Art. 153(4) EPC

(43) Date of publication:
**10.04.2024 Bulletin 2024/15**

(51) International Patent Classification (IPC):
**C01F 7/02** *(2022.01)* **C01F 7/022** *(2022.01)*
**C01F 7/027** *(2022.01)* **C08K 3/22** *(2006.01)*
**C08L 101/00** *(2006.01)*

(21) Application number: **22815976.0**

(22) Date of filing: **26.05.2022**

(52) Cooperative Patent Classification (CPC):
**C01F 7/02; C01F 7/022; C01F 7/027; C08K 3/22; C08L 101/00**

(86) International application number:
**PCT/JP2022/021614**

(87) International publication number:
**WO 2022/255226 (08.12.2022 Gazette 2022/49)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **04.06.2021 JP 2021094726**
**01.03.2022 JP 2022031333**

(71) Applicant: **Sumitomo Chemical Company, Limited Tokyo 103-6020 (JP)**

(72) Inventors:
• **NAKATA, Kunihiko**
  **Osaka-shi, Osaka 554-8558 (JP)**
• **ARISE, Ichiro**
  **Osaka-shi, Osaka 554-8558 (JP)**
• **EGAWA, Takamasa**
  **Osaka-shi, Osaka 554-8558 (JP)**
• **SHIMAZAKI, Yasuharu**
  **Osaka-shi, Osaka 554-8558 (JP)**
• **DAIMON UEHARA, Michiru**
  **Osaka-shi, Osaka 554-8558 (JP)**

(74) Representative: **Vossius & Partner Patentanwälte Rechtsanwälte mbB Siebertstrasse 3 81675 München (DE)**

(54) **ALUMINA PARTICLES AND RESIN COMPOSITION USING SAME**

(57) Provided is an alumina particle for use as a filler for resin compositions, which can improve the thermal conductivity of the resin composition over conventional resin compositions. It is an alumina particle having a particle diameter D50 of more than 100 $\mu$m at a cumulative value of 50% from the fine particle side in the cumulative particle size distribution, and having an $\alpha$-alumina rate of 90% or more; wherein the $\alpha$-alumina is a monocrystalline alumina. The alumina particle preferably has a Na content of 800 ppm or less. In addition, the alumina particle preferably has a particle diameter D10 of 70 to 135 $\mu$m at a cumulative value of 10% from the fine particle side in the cumulative particle size distribution.

EP 4 349 782 A1

[Figure 1]

EP 4 349 782 A1

CARRIER
OXYGEN
GAS 11

OXYGEN GAS
FEED SYSTEM 10

FEEDER 30

OXYGEN GAS
FOR
COMBUSTION 12

BAG FILTER

FUEL GAS
FEED SYSTEM 20

BURNER 41

FLAME FUSION
FURNACE 40

CYCLONE 50

BLOWER

BLOWER

**Description**

[Technical Field]

The present disclosure relates to alumina particles and a resin composition containing the alumina particles.

[Background Art]

Heat generated by energizing electronic components is dissipated through a heatsink. A technique of filling a space between the electronic component and the heatsink with a heat dissipation material for the purpose of improving heat dissipation efficiency is known.

One of the heat dissipation members is a resin composition comprising a resin and inorganic particles, and it is known that alumina particles can be utilized as the organic particles (for example, Patent Literatures 1 to 3).

Patent Literature 1 discloses an alumina particle, having an $\alpha$ phase content rate of 40% or less, an average roundness of 0.95 or more, and an average particle diameter of 100 $\mu$m or less, as an alumina particle capable of improving the flowability of a resin when highly filled into the resin. It discloses, as a method for producing alumina particles, a technique comprising fusing ground particles of electro-fused alumina by a flame fusion method and spraying water into a furnace to rapidly cool the fused particles.

Patent Literature 2 discloses, as an alumina particle capable of improving the viscosity and flowability of a composition when blended into a resin or the like, an alumina particle having an average sphericity of 0.93 or more and an $\alpha$-alumina rate of 95% or more. It discloses, as a method for producing alumina particles, a method comprising fusing a metallic aluminum powder, an alumina powder or a mixture thereof as a raw material by a flame fusion method, cooling to solidify it, and then subjecting it to reheat treatment.

Patent Literature 3 discloses a method of crushing electro-fused alumina with a jet mill and removing edges of the particle of the electro-fused alumina to obtain a roundish electro-fused alumina particle having an average particle diameter of 5 to 4,000 $\mu$m.

[Citation List]

[Patent Literature]

[Patent Literature 1]
International Publication No. WO 2009/133904
[Patent Literature 2]
International Publication No. WO 2008/053536
[Patent Literature 3]
Japanese Patent Laid-Open No. 2006-169090

[Summary of Invention]

[Technical Problem]

In recent years, a problem has been that the amount of heat generation in ICs increases due to the high integration of ICs in electronic devices, and that the amount of heat generation in electronic components increases due to the use of high-current driven electronic components resulting from electrification of electric vehicles, aircraft, and the like. There is a need for further improvement in the thermal conductivity of a resin composition in order to achieve more effective heat dissipation. There is also a need for minimization of the interface between a resin and a filler (alumina particles) to be used in the resin composition, that is, an increase the particle diameter of the alumina particles in order to achieve more effective heat dissipation.

However, the alumina particles disclosed in Patent Literatures 1 and 2 have not been investigated for further improvement in the thermal conductivity of the resin composition.

The alumina particles of Patent Literature 3 are not sufficient in the thermal conductivity, when they are mixed with a resin to form a resin composition.

In view of such circumstances, an object of one embodiment of the present invention is to provide alumina particles for use as a filler for resin compositions, which can improve the thermal conductivity of the resin composition over conventional resin compositions. An object of another embodiment of the present invention is to provide a resin composition containing alumina particles.

[Solution to Problem]

Aspect 1 of the present invention is:
an alumina particle having a particle diameter D50 of more than 100 $\mu$m at a cumulative value of 50% from the fine particle side in the cumulative particle size distribution, and having an $\alpha$-alumina rate of 90% or more; wherein the $\alpha$-alumina is a monocrystalline alumina.
Aspect 2 of the present invention is:
the alumina particle according to Aspect 1 having a Na content of 800 ppm or less.
Aspect 3 of the present invention is:
the alumina particle according to Aspect 1 or 2 having a particle diameter D10 of 70 to 135 $\mu$m at a cumulative value of 10% from the fine particle side in the cumulative particle size distribution.
Aspect 4 of the present invention is:
the alumina particle according to any one of Aspects 1 to 3 having a particle diameter D90 of 130 to 200 $\mu$m at a cumulative value of 90% from the fine particle side in the cumulative particle size distribution.
Aspect 5 of the present invention is:
the alumina particle according to any one of Aspects 1 to 4 having a circularity of 0.90 to 1.00.
Aspect 6 of the present invention is: the alumina particle according to any one of Aspects 1 to 5 having a density of 3.80 g/cm$^3$ or more.
Aspect 7 of the present invention is: a resin composition comprising a resin and the alumina particle according to any one of Aspects 1 to 6.

[Advantageous Effects of Invention]

The use of an alumina particle according to one embodiment of the present invention as a filler can provide a resin composition having a high thermal conductivity.

[Brief Description of Drawings]

[Figure 1] Figure 1 is a schematic diagram showing a device for performing a flame fusion process in a method for producing an alumina particle.
[Figure 2] Figure 2 is a conceptual diagram of a thermal diffusivity measuring device for performing a temperature wave thermal analysis method (TWA method) on one alumina particle.

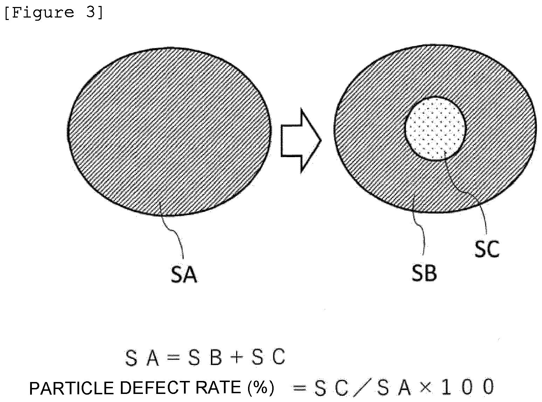

[Figure 3] Figure 3 is a schematic diagram for illustrating a method for calculating the particle defect rate.

[Description of Embodiments]

[Alumina particle]

The alumina particle according to an embodiment of the present invention is for use as a filler for resin compositions by mixing it with a resin. The alumina particle has a particle diameter D50 of more than 100 $\mu$m at a cumulative value of 50% from the fine particle side in the cumulative particle size distribution, and having an $\alpha$-alumina rate of 90% or more; wherein the $\alpha$-alumina is a monocrystalline alumina. The alumina particle can improve the thermal conductivity of a resin composition by having such characteristics. Each of these characteristics will be described in detail below.

(Particle diameter D50 at a cumulative value of 50% from fine particle side in cumulative particle size distribution)

For the alumina particle according to an embodiment of the present invention, the particle diameter D50 at a cumulative value of 50% from the fine particle side in the cumulative particle size distribution (hereinafter sometimes simply referred to as "D50") is more than 100 $\mu$m. The alumina particle is presumed to provide a resin composition having a high thermal conductivity when used as a filler for resin compositions for the following reasons.
When the D50 of the alumina particle is larger, the total of the surface areas (total surface area) of the alumina particles per unit mass is smaller. Therefore, when the alumina particles are mixed with a resin at a predetermined ratio to produce a resin composition, the use of the alumina particles having the larger average particle diameter can reduce the total of the areas (total area) of the interface between the alumina particles and the resin. It is believed that since the interface between the alumina particles and the resin scatters propagating photons, the thermal conductivity can be improved by reducing the total area of the interface.

The alumina particle of an embodiment of the present invention has a D50 of more than 100 μm. Therefore, when it is mixed with a resin at a predetermined ratio, the total area of the interface can be reduced and a resin composition having a higher thermal conductivity as compared to when the D50 is 100 μm or less can be produced.

The D50 of the alumina particle is preferably 105 μm or more, more preferably 110 μm or more, and particularly preferably 115 μm or more. The upper limit of the D50 is not limited, but it is preferably 160 μm or less, more preferably 155 μm or less, even more preferably 150 μm or less, further more preferably 140 μm or less, and particularly preferably 135 μm or less, from the viewpoint of providing a good kneadability with a resin and from the viewpoint of application to a filler for resin compositions. The D50 of more than 160 μm is not preferable because it is highly likely to result in a low circularity of the alumina particle even in the embodiment of the present invention.

For the D50 of an alumina particle, the particle size distribution of the alumina particle is measured based on the principle of a dynamic image analysis in accordance with ISO 13322-2, and the cumulative particle size distribution obtained from the measurement results is used to determine a particle diameter (D50) at a cumulative value of 50% from the fine particle side. For example, CAMSIZER (available from Verder Scientific Co., Ltd.) is used as a measurement device, and samples are sequentially introduced into the device, and particles passing in front of a camera are subjected to measurement while agglomerated particles are dispersed with dry air.

(α-Alumina rate)

Since α-alumina has a high thermal conductivity, the thermal conductivity of the alumina particle can be increased by increasing the content of α-alumina in the alumina particle. The alumina particle according to an embodiment of the present invention has a high α-alumina rate of 90% or more, which is an index of the content of α-alumina. Therefore, the alumina particle with a high thermal conductivity can be obtained.

The α-alumina rate is preferably 95% or more, and most preferably 100%.

As used herein, the term "α-alumina rate" refers to the content rate (% by volume) of α-alumina with respect to all alumina species contained in the alumina particles.

The α-alumina rate is determined by: subjecting the alumina particles to measurement by powder X-ray diffraction; determining, from the obtained diffraction spectrum, the peak height ($I_{25.6}$) of the α phase (012 plane) appearing at the position of 2θ = 25.6° and the peak height ($I_{46}$) of the η phase, χ phase, κ phase, θ phase and δ phase appearing at the position of 2θ = 46°; and calculating the α-alumina rate from the values of the peak heights by the following equation (1).

$$\alpha\text{-Alumina rate} = I_{25.6}/(I_{25.6} + I_{46}) \times 100\ (\%) \qquad (1)$$

The alumina particle according to an embodiment of the present invention most desirably has an α-alumina rate of 100%, but it may contain alumina species other than α-alumina (such as δ-alumina or θ-alumina), for example, in a proportion of about 10% or less, which does not interfere with the object of the present invention.

Alumina species other than α-alumina may be contained in any manner. For example, one alumina particle may contain both α-alumina and alumina species other than α-alumina, or one alumina particle may consist of only α-alumina and another alumina particle may consist of only alumina species other than α-alumina, or these alumina particles may be present in combination.

(α-Alumina is monocrystalline alumina)

In an embodiment of the present invention, the production conditions are controlled so that the α-alumina contained in an alumina particle is a monocrystalline alumina. As described above, α-alumina has a high thermal conductivity, and particularly when it is a monocrystalline alumina, it has a higher thermal conductivity than polycrystalline α-alumina. Therefore, the alumina particle containing α-alumina as a monocrystalline alumina can be further improved in the thermal conductivity.

The alumina particle may contain a small amount (such as about 10% or less) of a polycrystalline α-alumina together with a monocrystalline alumina, which does not interfere with the object of the present invention.

It can be confirmed by the SEM-EBSD method whether the α-alumina in the alumina particles is a monocrystalline alumina. It can be determined, by Phase MAP, whether the alumina species is α-alumina or alumina species other than α-alumina; and it can be then determined, by Image Quality (IQ) MAP, based on the presence or absence of clear crystal grain boundaries in the alumina particles, whether the α-alumina in the alumina particles is a monocrystalline or polycrystalline alumina.

It may be also confirmed, by the Debye-Scherrer method, whether the $\alpha$-alumina is a monocrystalline alumina.

In an embodiment according to the present invention, the alumina particle preferably has a Na content of 800 ppm or less.

When the alumina particles are used as a filler for resin compositions, the high Na content (such as 1000 ppm or more) may adversely affect electronic components and the like arranged adjacent to the resin composition. In addition, it has been believed that since the Na present in the alumina particles scatters propagating phonons, the alumina particles having a Na content of, for example, 100 ppm or more are unsuitable as a filler for resin compositions due to too low conductivity. For these reasons, it has been conventionally believed that when alumina particles are used as fillers for resin compositions, the Na content must be less than 100 ppm.

In contrast, the inventor of the present application has found that even when the alumina particle has a Na content of 100 ppm or more, it can achieve a thermal conductivity suitable for use as a filler for resin compositions if it has D50 of more than 100 $\mu$m and a $\alpha$-alumina rate of 90% or more and the $\alpha$-alumina contained in the alumina particle is a monocrystalline alumina. In particular, the Na content of 800 ppm or less is preferred and can improve the thermal conductivity of the alumina particle.

As used herein, the term "Na content" refers to the content determined in terms of the oxide, that is, the $Na_2O$ content (ppm by mass) determined when the Na contained in the alumina particle is converted to $Na_2O$, with respect to the alumina (in terms of $Al_2O_3$) contained in the alumina particle of 100% by mass.

The Na content is more preferably 700 ppm or less, and particularly preferably 600 ppm or less.

The lower limit of the Na content is not limited, but it is, for example, 1 ppm or more. Under the following circumstances, the lower limit of the Na content is preferably made higher (for example, more than 20 ppm).

A raw material for producing an alumina particle (alumina raw material particle) may contain Na. In order to make the Na content in the alumina particle extremely low, the alumina particle is required to be subjected to a treatment to remove the raw material-derived Na from the entire alumina particle (both the surface and inside of the alumina particle). Since the alumina particle according to an embodiment of the present invention are dense, it is difficult to remove Na from the inside of the alumina particle by washing of the alumina particle with water as described later.

However, as described above, the alumina particle according to an embodiment of the present invention can be used as a filler for resin compositions even when the Na content is 100 ppm or more. Therefore, a certain level of Na content is preferably allowed in order to omit the treatment for Na removal.

The Na content is preferably more than 20 ppm, more than 30 ppm, more than 50 ppm or more than 80 ppm, and more preferably 100 ppm or more.

Of the Na contained in the alumina particle, the Na present on the surface can be easily washed away by washing with water. The Na, which may adversely affect electronic components or the like, is mainly the Na present on the surface of alumina particle. Therefore, the adverse effect on electronic components or the like can be reduced by washing the alumina particle with water before mixing with a resin as a filler for resin compositions. However, since the Na that can be removed by washing with water is only a trace amount of Na present near the surface of the alumina particle, it is difficult to confirm a great reduction in the Na content even if the measurement values of the Na content in the alumina particle before and after washing with water are compared.

Since the Na that reduces the thermal conductivity of the alumina particle is mainly the Na present inside the alumina particle, the thermal conductivity of the alumina particle is presumed not to be improved significantly even if the alumina particle is washed with water.

The Na content in alumina particle is quantified by any known method such as glow discharge mass spectrometry, inductively coupled plasma atomic emission spectrometry (ICP-AES), inductively coupled plasma mass spectrometry (ICP-MS) or fluorometry, but inductively coupled plasma mass spectrometry (ICP-AES) is preferred in particular.

The alumina particle preferably has a particle diameter D10 at a cumulative value of 10% from the fine particle side in the cumulative particle size distribution of 70 $\mu$m or more, more preferably 75 $\mu$m or more or 80 $\mu$m or more, and particularly preferably 90 $\mu$m or more. D10 is preferably 135 $\mu$m or less, and more preferably 125 $\mu$m or less, 120 $\mu$m or less, 115 $\mu$m or less, 110 $\mu$m or less or 105 $\mu$m or less.

In addition, the alumina particle preferably has a particle diameter D90 at a cumulative value of 90% from the fine particle side in the cumulative particle size distribution of 130 to 200 $\mu$m. D90 is more preferably 130 to 190 $\mu$m, and particularly preferably 130 to 180 $\mu$m.

The alumina particle having such a particle diameter are preferable because it has a good flowability, can be filled in a large amount into a resin and are easy to handle.

The alumina particles preferably have a sharp particle size distribution, and D90/D10 is preferably 3.0 or less and more preferably 2.0 or less. The alumina particles having a sharper particle size distribution can be improved in the capture rate (recovery rate) of the particles that have been subjected to fusion and production, resulting in a better productivity. The alumina particles having a sharp particle size distribution are preferable because they are easily used as a filler for resin compositions and increase in the selectivity and flexibility when mixed with other particles.

Alumina raw material particles or alumina particles produced from the alumina raw material particles are preferably classified or sieved so that the alumina particles as a final product do not contain fine particles and coarse particles. For example, when the alumina raw material particles are classified or sieved to remove the fine particles and coarse particles and are used to produce the alumina particles, the fine particles and coarse particles in the resulting alumina particles can be reduced. Alternatively, the alumina particles produced from the alumina raw material particles may be classified or sieved to remove the fine particles and coarse particles.

For the alumina particles having no coarse particle, the particle diameter D100 (that is a maximum particle diameter of the particle) at a cumulative value of 100% from the fine particle side in the cumulative particle size distribution is preferably 500 $\mu$m or less, more preferably 400 $\mu$m or less, and particularly preferably 300 $\mu$m or less, from the viewpoint of improving the circularity.

In an embodiment of the present invention, when fine alumina raw material particles are used to produce alumina particles, the produced alumina particles tend to be polycrystalline alumina particles, alumina particles having a low $\alpha$-alumina rate, or alumina particles having a low density. Therefore, it is particularly preferable to remove the fine particles from the alumina raw material particles or to remove the fine particles from the alumina particles produced from the alumina raw material particles.

The D10, D90 and D100 of alumina particles can be measured by the same method and with the same device as those for the measurement of a D50 as described above. The particle size distribution of alumina particles is measured based on the principle of a dynamic image analysis in accordance with ISO 13322-2, and the cumulative particle size distribution obtained from the measurement results is used to determine a particle diameter (D10) at a cumulative value of 10% from the fine particle side, a particle diameter (D90) at a cumulative value of 90% from the fine particle side and a particle diameter (D100) at a cumulative value of 100% from the fine particle side. For example, CAMSIZER (available from Verder Scientific Co., Ltd.) is used as a measurement device, and samples are sequentially introduced into the device, and particles passing in front of a camera are subjected to measurement while agglomerated particles are dispersed with dry air.

The alumina particle having a circularity of 0.90 to 1.00 is preferable, can provide a good kneadability with a resin, can increase the flowability of a composite obtained after kneading, and can be reduced in abrasion to other members.

Since the alumina particles are generally hard particles, they preferably have a circularity of 0.90 or more for use as a filler for resin compositions for electronic components. However, it is difficult to obtain alumina particles having a circularity of 0.90 or more only by allowing alumina particles having a low circularity to collide with each other or grinding the alumina particles having a low circularity. Such collision and grinding for a long period of time may also generate a large amount of fine powder. In addition, the new hydrophilic surface generated by grinding may reduce the miscibility with a resin.

The circularity (SPHT) was analyzed in accordance with ISO 9276-6. It is calculated from SPHT = $4\pi A/P^2$, wherein A is a measurement value of the area of the projected particle image and P is a measurement value of the perimeter of the projected particle image.

The circularity of the alumina particle can be measured with a measurement device (such as CAMSIZER X2, available from Verder Scientific Co., Ltd.) based on the principle of a dynamic image analysis in accordance with ISO 13322-2.

The alumina particle preferably has a density of 3.80 g/cm$^3$ or more.

The presence of internal voids in the alumina particles reduces the thermal conductivity of the alumina particles. Therefore, the alumina particles desirably have few internal voids. Examples of the technique for confirming internal voids include a method of direct observation by image analysis of cross-sectional SEM images, X-ray fluoroscopic images, or the like and a method of indirect confirmation by measuring the density of alumina particles.

The alumina particles having a density of 3.80 g/cm$^3$ or more are preferable, and it can provide alumina particles having a small level of internal voids (or no internal voids), that is, alumina particles having a high thermal conductivity.

The density of alumina particles is more preferably 3.85 g/cm$^3$ or more, 3.88 g/cm$^3$ or more or 3.89 g/cm$^3$ or more, and particularly preferably 3.90 g/cm$^3$ or more.

The density of alumina particles is measured by a pycnometer method in accordance with JIS R 1620-1995.

The measurement is performed 5 times or more. The measurement can be performed, for example, with AccuPyc 1330 (Micromeritics Instrument Corporation).

In an embodiment according to the present invention, the thermal conductivity (W/mK) of one alumina particle can be increased. The thermal conductivity of one alumina particle is preferably 25 W/mK or more, more preferably 28 W/mK or more, particularly preferably 30 W/mK or more, and most preferably 33 W/mK or more.

[Method for producing alumina particles]

A method for producing alumina particles according to an embodiment of the present invention will be described.

A raw material for the alumina particles to be used is alumina raw material particles made of monocrystalline α-alumina and having a particle diameter D50 of more than 100 μm at a cumulative value of 50% from the fine particle side in the cumulative particle size distribution. Alumina particles are produced from the alumina raw material particles by a flame fusion method.

It has been a conventional popular theory that since the raw material particles are fused and reset for their crystal structure when they are put into a flame, the features of the crystal structure of the raw material particles do not affect the crystal structure of the particles after spheroidization with the flame. However, it has been unexpectedly found that when monocrystalline particles are used as raw material particles, the features of the crystal structure of the raw material particles can be inherited even after spheroidization.

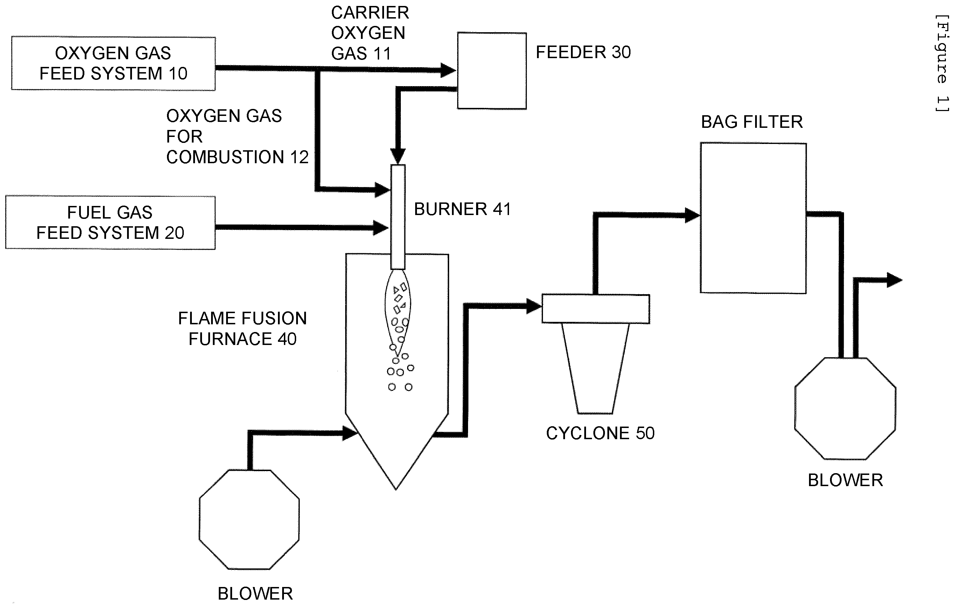

In the flame fusion process, for example, a device as shown in Figure 1 is used. The flame fusion process can provide alumina particles having an α-alumina rate of 90% or more wherein the α-alumina is a monocrystalline alumina.

In order to use the raw material particles of monocrystalline alumina and utilize the feature of the crystal structure of the monocrystalline alumina even after spheroidization, the particle diameter of the alumina raw material particles to be used; the feed rate of the alumina raw material particles into a flame fusion furnace of the device; the flame intensity; and the distance between the flame and the alumina raw material particles, and the like is controlled.

In order to produce alumina particles having a D50 of more than 100 μm, alumina raw material particles having a D50 of, for example, 110 μm or more are used. The alumina raw material particles preferably have a D50 of preferably 120 μm or more such as 150 μm.

Even when the alumina raw material particles have as D50 of, for example, 110 μm or more, the individual alumina raw material particles having a particle diameter of less than 110 μm may be included. Therefore, the resulting alumina particles may contain polycrystalline α-alumina and/or alumina species other than α-alumina. However, by using the alumina raw material particles having a D50 of 110 μm or more, the content of the polycrystalline α-alumina and/or the alumina species other than α-alumina can be suppressed to such a low level that is allowed in the present invention.

A method for producing alumina particles with granulated raw material particles by a flame fusion method is conventionally known, but the resulting alumina particles may contain many internal voids therein. In the present invention, since ungranulated monocrystalline α-alumina itself is used as the alumina raw material particles, alumina particles having few internal voids (or no internal voids) and a high density can be obtained.

The D50 of the alumina raw material particles can be measured by the same method as the method for the measurement of a D50 as described above.

It can be confirmed, by the same method as the above-described method for confirming that α-alumina in alumina particles is monocrystalline, that the alumina raw material particles are monocrystalline α-alumina.

As the raw material for the alumina raw material particles, sapphire, and monocrystalline α-alumina and the like made by a melt growth method such as a CZ method, a Bernoulli method, a Kyropoulos method, a Bridgman method or an EFG method can be used. These raw materials can be ground and sieved with a mesh having a desired opening to prepare alumina raw material particles having a predetermined D50.

The alumina raw material particle may contain a small level (such as about 10% by mass or less) of alumina species other than α-alumina (such as δ-alumina or θ-alumina), or may contain a small level (such as about 10% by mass or less) of polycrystalline α-alumina together with monocrystalline α-alumina, both of which do not interfere with the object of the present invention.

In the flame fusion process, the feed rates of alumina raw material particles, a fuel gas and an oxygen gas preferably satisfy the following expressions (2) and (3):

$$0.625 \leq R/F \ (kg/Nm^3) \ \leq 5.000 \qquad (2)$$

; and

$$0.125 \leq R/S \ (kg/Nm^3) \ \leq 1.500 \qquad (3)$$

wherein F represents the feed rate ($Nm^3$/hour) of a fuel gas, S represents the feed rate ($Nm^3$/hour) of an oxygen gas, and R represents the feed rate (kg/hour) of alumina raw material particles.

The feed rate of an oxygen gas (S) is the sum of the feed rate of an oxygen gas for combustion and the feed rate of a carrier oxygen gas. The carrier oxygen gas is an oxygen gas that is primarily intended to transport the alumina raw material particles, but after the transport, it is utilized for combustion in the same manner as the oxygen gas for combustion.

As defined by the expression (2), the ratio (R/F) of the feed rate of alumina raw material particles to the feed rate of a fuel gas is preferably 0.625 $kg/Nm^3$ or more and 5.000 $kg/Nm^3$ or less. In addition, as defined by the expression (3), the ratio (R/S) of the feed rate of alumina raw material particles to the feed rate of an oxygen gas is preferably 0.125

kg/Nm$^3$ or more and 1.500 kg/Nm$^3$ or less.

The feed rate of a fuel gas F (Nm$^3$/hour) and the feed rate of an oxygen gas S (Nm$^3$/hour) are factors that determine the flame intensity in a furnace in the flame fusion process. Both R/F and R/S serve as indexes of the relationship between the flame intensity in the furnace and the feed rate of alumina raw material particles in the flame fusion process.

When R/F and R/S are large, the feed rate of alumina raw material particles is large, and the amount of energy provided by the flame to each alumina raw material particle decreases (that is, the fusion of the alumina raw material particles is suppressed).

When R/F and R/S are small, the feed rate of alumina raw material particles is small and the amount of energy provided by the flame to each alumina raw material particle increases (that is, the fusion of the alumina raw material particles is promoted).

Therefore, controlling R/F and R/S is one method of controlling the fusion state of alumina raw material particles in the flame fusion process. When each of R/F and R/S is within the preferable range, the alumina raw material particles can be spheroidized while maintaining the crystal structure of the raw material particles in the flame fusion process.

R/F is more preferably 0.625 kg/Nm$^3$ or more and 4.500 kg/Nm$^3$ or less, and particularly preferably 1.000 kg/Nm$^3$ or more and 4.500 kg/Nm$^3$ or less.

R/S is more preferably 0.125 kg/Nm$^3$ or more and 1.333 kg/Nm$^3$ or less, particularly preferably 0.125 kg/Nm$^3$ or more and 1.250 kg/Nm$^3$ or less, and most preferably 0.200 kg/Nm$^3$ or more and 1.000 kg/Nm$^3$ or less.

The feed rate of a fuel gas F is preferably less than 20 Nm$^3$/hour. The flame length can be changed by the feed rate of a fuel gas, and when the feed rate of a fuel gas is larger, the flame length is longer and the residence time of the particles in the flame is longer. When the feed rate of a fuel gas is smaller, the flame length is shorter and the residence time of the particles in the flame can be shortened. That is, the residence time of the alumina raw material particles in the flame can be changed, and the degree (time) of fusion of the alumina raw material particles in the flame can be changed. In addition, the $\alpha$-alumina rate and density of the alumina particles can be increased while maintaining the crystal structure of the alumina raw material particles.

Examples of the fuel gas in the present invention include propane, butane, propylene, acetylene and hydrogen. Propane (for example, liquefied propane gas (LPG)) is particularly preferred.

By producing alumina particles via such a flame fusion process, the Na content in the resulting alumina particles can be made lower than the Na content in the alumina raw material particles.

In the flame fusion process, when solidifying the fused alumina raw material particles, they may be passed through a region having a temperature of 600°C to 1,500°C, preferably 800°C to 1,400°C, and more preferably 1,000°C to 130°C in order to slow down the cooling rate. By solidifying the spheroidized alumina particles while passing them through such a region, the $\alpha$-alumina rate can be increased.

As a post-process of the flame fusion process described above, a process of reheating the cooled and solidified alumina particles before recovering them may be added. Reheating the cooled and solidified alumina particles can reduce the proportion of alumina species other than $\alpha$-alumina and can increase the $\alpha$-alumina rate. The temperature in the reheating process is, for example, preferably 900°C or more, and more preferably 1000°C or more. As a method for reheating, external heating with a heater or the like, heating by further gas combustion, or the like can be applied.

[Resin composition]

The use of the alumina particle according to an embodiment of the present invention as a filler for resin compositions can provide a resin composition having a high thermal conductivity. The resin composition comprises a resin and an alumina particle according to an embodiment of the present invention.

Alumina particles according to an embodiment of the present invention can improve the thermal conductivity of a resin without impairing the flexibility peculiar to the resin. The blend ratio is preferably 5 to 75% by volume of a resin and 95 to 25% by volume of alumina particles with respect to the resin composition (composite).

A method for producing a resin composition will be described.

A resin composition can be obtained by mixing the alumina particles of the present invention with a resin using any known method commonly used. For example, when the resin is liquid (for example, a liquid epoxy resin), the resin composition can be obtained by mixing the liquid resin, alumina particles and a curing agent followed by curing the mixture with heat or ultraviolet light. The curing agent, mixing method and curing method to be used can be known ones. On the other hand, when the resin is solid (for example, a polyolefin resin or acrylic resin), the resin composition of interest can be obtained by mixing alumina particles and the resin followed by kneading by any known method such as melt kneading.

The resin to be used in the resin composition can be selected from a thermoplastic resin, a thermoplastic elastomer and a thermosetting resin. The resin may be used alone or in combination of two or more.

Examples of the thermoplastic resin include a polyolefinic resin such as polyethylene, polypropylene or an ethylene-propylene copolymer; polymethylpentene, polyvinyl chloride, polyvinylidene chloride, polyvinyl acetate, an ethylene-vinyl acetate copolymer, polyvinyl alcohol, polyvinyl acetal; a fluorine-based polymer such as polyvinylidene fluoride or polytetrafluoroethylene; polyethylene terephthalate, polybutylene terephthalate, polyethylene naphthalate, polystyrene, polyacrylonitrile, a styrene-acrylonitrile copolymer, an acrylonitrile-butadiene-styrene copolymer (ABS) resin, a polyphenylene-ether copolymer (PPE) resin, a modified PPE resin, aliphatic polyamides, aromatic polyamides, polyimide, polyamideimide, polymethacrylic acid, polymethacrylic acid ester such as methyl polymethacrylate, polyacrylic acids, polycarbonate, polyphenylene sulfide, polysulfone, polyethersulfone, polyethernitrile, polyetherketone, polyketone, a liquid crystal polymer, a silicone resin and an ionomer.

Examples of the thermoplastic elastomer include a styrene-butadiene block copolymer or a hydrogenated product thereof, styrene-isoprene block copolymer or a hydrogenated product thereof, a styrene-based thermoplastic elastomer, an olefin-based thermoplastic elastomer, a vinyl chloride-based thermoplastic elastomer, a polyester-based thermoplastic elastomer, a polyurethane-based thermoplastic elastomer and a polyamide-based thermoplastic elastomer.

Examples of the thermosetting resin include a crosslinked rubber, an epoxy resin, a phenolic resin, a polyimide resin, an unsaturated polyester resin and a diallyl phthalate resin. Examples of the crosslinked rubber include natural rubber, acrylic rubber, butadiene rubber, isoprene rubber, styrene-butadiene copolymer rubber, nitrile rubber, hydrogenated nitrile rubber, chloroprene rubber, ethylene-propylene copolymer rubber, chlorinated polyethylene rubber, chlorosulfonated polyethylene rubber, butyl rubber, halogenated butyl rubber, fluororubber, urethane rubber and silicone rubber.

The resin to be used in the resin composition is preferably a polyolefin resin, an acrylic resin, a polyimide resin, a polyamide resin, a polyamideimide resin, an epoxy resin, a phenolic resin and a silicone resin, from the viewpoint of the processability and properties.

These resin compositions may optionally further contain any known additive, alone or in combination of two or more, such as a plasticizer, a curing accelerator, a coupling agent, a filler, a pigment, a flame retardant, an antioxidant, a surfactant, a compatibilizer, a weathering agent, an anti-blocking agent or an antistatic agent, so long as it does not impair the effects of the present invention.

The alumina particle according to the present embodiment and the resin composition comprising the alumina particle are particularly suitable for use as a heat dissipation material. Therefore, in one aspect of the present disclosure, a heat-dissipating alumina particle and a heat-dissipating resin composition can be provided.

However, the alumina particle and the resin composition according to the present embodiment can have low-dielectric loss properties by further having the physical properties described in [Other physical properties] below. Therefore, in another aspect of the present disclosure, a low dielectric loss alumina particle and a low dielectric loss resin composition can be provided. In further another aspect of the present disclosure, a heat dissipation/low-dielectric loss alumina particle and a heat dissipation/low-dielectric loss resin compositions can be provided by taking advantage of both heat dissipation and low-dielectric loss properties.

[Other physical properties]

The alumina particle according to the present embodiment and the resin composition comprising the alumina particle can provide a low-dielectric loss resin composition by further having the following properties. The "other physical properties" described below can be measured using the measurement method described in the Examples.

(Intraparticle defect rate)

The inclusion of voids or amorphous layers (referred to as "particle defects") inside the alumina particles causes an increase in dielectric loss. Therefore, the intraparticle defect rate of the alumina particles is preferably low, particularly preferably 20% or less, and more preferably 15% or less. Such a low intraparticle defect rate of the alumina particles can further reduce a dielectric loss of the resin composition when the alumina particles is used as a filler for resin compositions.

(Average aspect ratio of impurity particles)

The alumina particles may contain impurity particles (noncircular and elongated alumina particles). The average aspect ratio of the impurity particles is preferably more than 1.2 and 5.0 or less, and particularly preferably 3 or less or 2.5 or less. The inclusion of a small amount of such impurity particles in the alumina particles can improve the filling rate of the alumina particles and further reduce the dielectric loss of the resin composition, when the alumina particles is used as a filler for resin compositions.

(Ratio of total length L2 of boundary lines inside alumina particle to length L1 of outer edge of alumina particle)

When the alumina particle has fewer grain boundaries and voids inside thereof, the dielectric loss of the alumina particle is lower. Accordingly, the ratio (L2/L1) of the total length L2 of the boundary lines inside the alumina particle to the length L1 of the outer edge of the alumina particle is introduced as an index of the grain boundary content inside the alumina particle.

The alumina particle having a small value of L2/L1 has a small content of boundary lines and a low dielectric loss, wherein L1 represents the length of the outer edge of one alumina particle and L2 represents the total length of the boundary lines of the alumina particle. In particular, the ratio (L2/L1) (%) of 100% or less is preferred and can further reduce the dielectric loss of the resin composition when used as a filler for resin compositions. The ratio (L2/L1) is more preferably 80% or less, even more preferably 50% or less, and particularly preferably 40% or less.

The "total length L2 of the boundary lines" is the sum of the boundary lines included inside the alumina particle and does not include the outer edge of the alumina particle. The total length L2 of the boundary lines is the sum of the total length L3 of the grain boundaries inside the alumina particle and (if voids are included inside the alumina particle) the total length L4 of the inner walls of the voids) (that is, L2 = L3 + L4).

Measurements of L1, L2, L3 and L4 are preferably performed for alumina particles made of $\alpha$-alumina.

(Number of contact points between alumina particles in resin composition)

An increase in the number of contact points between adjacent alumina particles (that is, the number of interfaces between particles) in a resin composition results in an increase in the dielectric loss of the resin composition. Therefore, the number of contact points between alumina particles in the resin composition is preferably 40 or less in an observation range of 650 $\mu$m $\times$ 750 $\mu$m (equivalent to 82 or less per mm$^2$ of an observation range). When such alumina particles are used, the dielectric loss of the resin composition can be further reduced.

The number of contact points between alumina particles is more preferably 65/mm$^2$ or less, particularly preferably 50/mm$^2$ or less or 30/mm$^2$ or less in terms of the number of contact points in an observation range of 1 mm$^2$. For heat dissipation properties, the number of contact points between alumina particles is preferably 1 or more in an observation area of 650 $\mu$m $\times$ 750 $\mu$m (equivalent to 2 or more per mm$^2$ of an observation area).

The number of contact points between alumina particles can serve as an index of the dispersity of particles, and when the number of contact points is smaller, the alumina particles are dispersed more uniformly in the resin.

(BET specific surface area of alumina particle)

Since the alumina particle according to the present embodiment has few irregularities on the particle surface and thereby has a low specific surface area, it is difficult to measure the BET specific surface area accurately by the N$_2$ gas adsorption method. The value of the N$_2$-BET specific surface area is preferably 0.05 m$^2$/g or less or 0.02 m$^2$/g or less, more preferably 0.01 m$^2$/g or less, and particularly preferably less than 0.01 m$^2$/g. For the alumina particles of Test No. 3 to 6, the values were less than 0.01 m$^2$/g by N$_2$-BET specific surface area measurement. When the BET specific surface area is measured with a krypton gas (Kr) as an adsorption gas, the BET specific surface area of alumina particle having a low specific surface area can be measured more accurately.

When the alumina particle has few irregularities on the particle surface, the interface between the alumina particle and a resin is reduced, so that the dielectric loss of the resin composition can be reduced when used as a filler for resin compositions. Therefore, the alumina particle having a BET specific surface area S1 (m$^2$/g) of 0.10 m$^2$/g or less as measured with a Kr gas is preferred, and can further reduce the dielectric loss of the resin composition when used as a filler for a resin composition. The Kr-BET specific surface area S1 is more preferably 0.08 m$^2$/g or less, and particularly preferably 0.07 m$^2$/g or less.

The Kr-BET specific surface area S1 may be 0.01 m$^2$/g or more, or may be 0.02 m$^2$/g or more.

Another index of the irregularities on the surface of an alumina particle is the ratio (S1/S2) (/g) of the BET specific surface area S1 (m$^2$/g) as measured with a Kr gas to the ideal spherical area S2 (m$^2$). The alumina particle having the ratio (S1/S2) of 95 $\times$ 10$^5$/g or less is preferred, and can further reduce the dielectric loss of the resin composition when used as a filler for resin compositions. The ratio (S1/S2) is more preferably 40 $\times$ 10$^5$/g or less, and particularly preferably 20 $\times$ 10$^5$/g or less.

The ideal spherical area S2 (m$^2$) refers to the surface area of a perfectly spherical particle having a particle diameter equivalent to a D50, and is calculated from the formula for the surface area of a sphere ($4\pi r^2$).

The irregularities on the particle surface may be also evaluated by using a pore distribution, a pore volume, or the like as another confirmation method. The pore volume of an alumina particle will be described later.

(Content of bring-in moisture by alumina particles and resin)

If the content of bring-in moisture by alumina particles (the content of moisture contained in alumina particles) is large, the resin composition produced using the alumina particles has a large dielectric loss. In addition, if the content of bring-in moisture by alumina particles is large, the moisture may exude from the resin, which may adversely affect electronic components and the like arranged adjacent to the resin composition. Therefore, the content of bring-in moisture by alumina particles is preferably smaller.

A ratio ($\Delta$Ma/$\Delta$Mr) of the content of bring-in moisture $\Delta$Ma by the alumina particles to the content of bring-in moisture $\Delta$Mr (ppm) by the resin is introduced as an index of the content of bring-in moisture by the alumina particles.

The ratio $\Delta$Ma/$\Delta$Mr is preferably 0.2 or less, and more preferably 0.1 or less. Since the content of bring-in moisture $\Delta$Ma by the alumina particles is extremely small compared to the content of bring-in moisture by the resin, the dielectric loss of the resin composition can be further reduced when the alumina particles are used as a filler for resin compositions.

(Pore volume of alumina particle)

The pore volume of the alumina particle is preferably 0.0003 cm$^3$/g or less as measured by the krypton adsorption method.

Similar to the Kr-BET specific surface area, the pore volume serves as an index for recognizing the degree of irregularities on the particle surface. Controlling the pore volume of the first alumina particle to the above range can further improve the moldability of a mixture.

The pore volume is more preferably 0.00009 cm$^3$/g or less, and particularly preferably 0.00007 cm$^3$/g or less. The lower limit of the pore volume is not limited, but it may be, for example, 0.000001 cm$^3$/g or more, or even 0.000005 cm$^3$/g or more.

[Examples]

(Preparation of alumina raw material particles)

Raw material particles made of monocrystalline alumina were prepared as a raw material 1. A raw material 2 is raw material particles, made of another monocrystalline alumina, having particles of 50 $\mu$m or less removed by sieving. The alumina raw material particles of each of the raw materials 1 and 2 had an angular shape.

Table 1 shows the physical properties of the raw materials 1 and 2. The method for measuring each value of the physical properties of the alumina raw material particles was the same as the method for measuring each value of the physical properties of the alumina particles described later.

[Table 1]

| Alumina raw material particles | D10 | D50 | D90 | Density (g/cm$^3$) | Circularity | Na content (ppm) | $\alpha$-Alumina rate (%) |
|---|---|---|---|---|---|---|---|
| Raw material 1 | 115 | 150 | 185 | 3.96 | 0.81 | 2100 | 100 |
| Raw material 2 | 63 | 69 | 93 | 3.96 | 0.71 | 100 | 100 |

(Production of alumina particles)

Alumina particles were prepared with a device as shown in Figure 1. An oxygen gas from an oxygen gas feed system 10 was branched into two, one (a carrier oxygen gas 11) being fed to a feeder 30, and another (an oxygen gas for combustion 12) being fed to a burner 41 of a flame fusion furnace 40. Alumina raw material particles fed to the feeder 30 were transported to the burner 41 of the flame fusion furnace 40 by the carrier oxygen gas 11. A combustion gas (LPG) was fed from a gas feed system 20 to the burner 41. In the burner 41, a high-temperature flame of 2,150°C or more was formed by the fuel gas and the oxygen gas for combustion 12, and the alumina raw material particles dispersed in the carrier oxygen gas 11 were fed thereto. As a result, the alumina raw material particles were fused and spheroidized in the flame fusion furnace 40. Thereafter, the spheroidized alumina particles were classified by a cyclone 50 to obtain alumina particles captured by the cyclone 50.

For Sample Nos. 1 to 4, the obtained alumina particles were used as they were for various measurements. For samples of Sample Nos. 5 and 6, the following treatments were additionally performed.

For Sample No. 5, the alumina raw material particles (raw material 1) were sieved through a sieve with an

opening of 132 μm, and the alumina raw material particles on the sieve were used as the raw material. The obtained alumina particles were further washed with an acid to remove Na, and then used for various measurements.

For Sample No. 6, the obtained alumina particles were classified with both a sieve with an opening of 70 μm and a sieve with an opening of 135 μm, and were used for various measurements.

Table 2 summarizes the ratios R/F and R/S, wherein F represents the feed rate (Nm$^3$/hour) of a fuel gas, S represents the feed rate (Nm$^3$/hour) of an oxygen gas and R represents the feed rate (kg/hour) of alumina raw material particles, in the flame fusion process. The feed rate of an oxygen gas S is the sum of the feed rate of a carrier oxygen gas 11 and the feed rate of an oxygen gas for combustion 12. The feed rate of a fuel gas F was less than 20 Nm$^3$/hour.

[Table 2]

|  | Sample No. | Alumina raw material particles | R / F | R / S |
|---|---|---|---|---|
| Example | 1 | Raw material 1 | 0.625 | 0.125 |
| Comparative Example | 2 | Raw material 2 | 0.625 | 0.125 |
| Example | 3 | Raw material 1 | 2.222 | 0.444 |
| Example | 4 | Raw material 1 | 3.333 | 0.667 |
| Example | 5 | Raw material 1 | 1.667 | 0.333 |
| Example | 6 | Raw material 1 | 4.444 | 0.889 |

(1) Measurement of particle diameters D10, D50 and D90 and circularity of alumina particles

The particle size distribution of alumina particles of each of Sample Nos. 1 to 6 was measured and the average values of the particle diameters of alumina particles, that is, a particle diameter D10 at a cumulative value of 10%, a particle diameter D50 at a cumulative value of 50% and a particle diameter D90 at a cumulative value of 90% were determined.

Each of the particle size distribution and circularity of the alumina particles was measured with CAMSIZER X2 (available from Verder Scientific Co., Ltd.), a measurement device based on the principle of a dynamic image analysis in accordance with ISO 13322-2. The measurement was performed by a dry method, and each of the samples was sequentially charged into the device, and the particles passing in front of the camera was subjected to the measurement while the aggregated particles were dispersed with dry air at 50 kPa. A 3 g portion of each sample was weighed out and the measurement was performed once. The same measurement was repeated three times, and the particle size distribution and circularity were analyzed from the cumulative average of these results. The particle diameter was a circle-equivalent particle diameter. The circle-equivalent particle diameter refers to a particle diameter of a perfect circle having the same area as the projected particle image. The particle diameter was based on the volume.

The circularity (SPHT) was analyzed in accordance with ISO 9276-6. It was calculated from SPHT = $4\pi A/P^2$ wherein A is a measurement value of the area of the projected particle image and P is the measurement value of the perimeter of the projected particle image.

Table 3 shows these measurement results.

[Table 3]

|  | Sample No. | Alumina raw material particles | Alumina particles | | | |
|---|---|---|---|---|---|---|
|  |  |  | D10 | D50 | D90 | Circularity |
|  |  |  | (μm) | (μm) | (μm) | |
| Example | 1 | Raw material 1 | 86 | 112 | 143 | 0.95 |
| Comparative Example | 2 | Raw material 2 | 51 | 63 | 77 | 0.96 |
| Example | 3 | Raw material 1 | 98 | 123 | 154 | 0.95 |
| Example | 4 | Raw material 1 | 100 | 125 | 162 | 0.92 |
| Example | 5 | Raw material 1 | 114 | 136 | 162 | 0.95 |
| Example | 6 | Raw material 1 | 96 | 116 | 143 | 0.94 |

(2) Measurement of density of alumina particle

The density of the alumina particle of each of Sample Nos. 1 to 6 was measured. Table 4 shows the measurement results.

The density was measured in accordance with JIS R 1620-1995. The measurement method and measurement conditions were as follows.

- Measurement method: gas replacement method
- Sample drying: at 200°C for 8 hours or more
- Device to be used: Accupic 1330 (Micromeritics Instrument Corporation)
- Measurement conditions

Number of purges: 10
Purge fill pressure: 15.0 psig
Number of measurements: 5
Measurement fill pressure: 15.0 psig
Equilibrium pressure: 0.005 psig/min
Whether the measurement was performed with the accuracy set: Yes
Tolerance of variation: 0.05%
Sample cell size: 10 cm$^3$

(3) Confirmation of crystal state of alumina particle

The crystal state of the alumina particle of each of the Sample Nos. 1 to 6 was confirmed by EBSD (electron backscatter diffraction measurement). The measurement method and measurement conditions were as follows.

- Device to be used

Ion milling device: IM-4000 (available from Hitachi, Ltd.)
Ion sputtering device: E-1030 (available from Hitachi, Ltd.)
Ultra-high resolution field emission scanning electron microscope: JSM-7800F Prime (available from JEOL Ltd.)
Electron backscatter diffraction device: Digiview V (available from TSL Solutions)

- Measurement conditions
  Accelerating voltage: 20.0 kV (EBSD analysis)
- Measurement procedure

A sample for observing a cross-section was prepared as follows. Alumina particles were embedded in a resin, and the resin and the alumina particles were then cut with a diamond cutter. Thereafter, Pt was vapor-deposited on the cross-section as a protective film, and the cross-section was prepared by an Ar ion milling. It was fixed to a SEM sample stage with a Cu double-sided tape, and was subjected to EBSD measurement without vapor deposition.
For EBSD measurement, in Phase MAP and Image Quality (IQ) MAP in the same area of at least 400 × 250 μm, when the proportion of α-alumina particles with no grain boundary observed is 80% or more with respect to all α-alumina particles in the measurement field, the α-alumina particles were evaluated as good O, and when the proportion of α-alumina particles with no grain boundary observed was less than 80% was evaluated as ×.

(4) Measurement of Na content of alumina particle

The Na content was measured for the alumina particle of each of Sample Nos. 1 to 6. The detailed measurement method and measurement conditions were as follows.

- Sample and number of samples: alumina particle, 2 test specimens in total
- Analysis, test items
  Quantitative analysis of Na
- Analysis, test methods
  Na quantitative analysis: acid dissolution/ICP-AES method

A powder sample (alumina particles) was weighed out in a sealed container. An acid was added thereto, subjected to acid decomposition treatment under pressure, allowed to cool, and diluted with ultrapure water to provide an analysis sample. Then, the Na content in the analysis sample was measured by ICP-AES (inductively coupled plasma atomic emission spectrometer), and the Na content in the powder sample (alumina powder) was calculated.

(5) Measurement of $\alpha$-alumina rate in alumina particle

The $\alpha$-alumina rate in the alumina particle of each of Sample Nos. 1 to 6 was measured. Table 4 shows the measurement results.

The $\alpha$-alumina rate was determined by subjecting a sample of the alumina particle to measurement with a powder X-ray diffractometer (available from Rigaku Corporation) to obtain a diffraction spectrum. Measurement conditions were as follows: an X-ray source: CuK$\alpha$; an X-ray output: 45 kV, 200 mA; and a scanning speed: 10 deg/min.

From the obtained diffraction spectrum, the peak height ($I_{25.6}$) of the $\alpha$ phase (012 plane) appearing at the position of $2\theta = 25.6°$ and the peak height ($I_{46}$) of the $\eta$ phase, $\chi$ phase, $\kappa$ phase, $\theta$ phase and $\delta$ phase appearing at the position of $2\theta = 46°$; were read out and subjected to calculation by the following equation (1) to determine an $\alpha$-alumina rate.

$$\alpha\text{-Alumina rate} = I_{25.6}/(I_{25.6} + I_{46}) \times 100 \ (\%) \qquad (1)$$

Table 4 summarizes these measurement results, confirmation results and calculation results.

[Table 4]

| | Sample No. | Density (g/cm$^3$) | Crystal state | Na content (ppm) | $\alpha$-Alumina rate (%) |
|---|---|---|---|---|---|
| **Example** | 1 | 3.92 | ○ | 450 | 98.5 |
| **Comparative Example** | 2 | 3.65 | × | 40 | 78.0 |
| **Example** | 3 | 3.92 | ○ | 500 | 97.9 |
| **Example** | 4 | 3.92 | ○ | 550 | 99.3 |
| **Example** | 5 | 3.92 | ○ | 170 | 98.0 |
| **Example** | 6 | 3.92 | ○ | 580 | 94.2 |

(6) Measurement of thermal diffusivity and thermal conductivity of resin composition (composite)

An epoxy resin (base resin: cold setting embedding resin type 53 (available from Sankei Co., Ltd.) 010-8140; a curing agent: cold setting embedding resin type 53 (available from Sankei Co., Ltd.) 010-8143) and alumina particles (the raw material 1 and each of Sample Nos. 1 to 6) were blended at a blend ratio shown in Table 5, and stirred and mixed using a Awatori Rentaro (available from THINKY CORPORATION) to obtain an epoxy resin-filler (alumina particles) composite.

A glass cloth tape was attached to a PET film to prepare a frame for determining the outer shape of the film, and the frame was placed on an aluminum plate. The composite obtained by stirring and mixing was poured into the frame and overlaid with the PET film so that air is not contained. Another aluminum plate was further placed thereon, heated to 50 to 70°C and allowed to stand to cure the resin. The curing time was about 3 hours at 50°C or about 1 hour at 70°C.

After curing was completed, it was allowed to cool. When the temperature of the aluminum plate decreased to about room temperature, two PET films were peeled off from both sides of the cured composite to obtain a sheet-like sample of the composite for measurement.

The thermal diffusivity, specific heat and density of the obtained sheet-like sample were measured to determine the thermal conductivity.

The thermal diffusivity was measured for a sample piece for measurement, of 10 mm long × 10 mm wide × 0.1 mm thick, prepared from the sheet-like sample of the resin composition described above, at room temperature by a temperature wave thermal analysis method (TWA method). The measurement device used was ai-Phase Mobile available from ai-Phase Co., Ltd.

The thermal diffusivity was measured at arbitrary three points for one sample piece for measurement, and the average value was calculated from the measurement results at the three points and used as the measurement value. For the thermal conductivity, the measurement value of the composite sample of "epoxy resin + raw material 1" was used as a reference, and the measurement values of the other measurement samples were normalized thereto.

For comparison, a sheet-like sample made of an epoxy resin alone was prepared and similar measurements and calculations were performed.

The value of specific heat used for determining the thermal conductivity was each value, calculated from the blend ratio of the resin and alumina particles, shown in Table 5.

The density was measured with an electronic densimeter MDS-300 (Alfa Mirage Co., Ltd.).

The density was determined by the Archimedes method (solid density measurement), based on the following equation (4). The specific gravity was calculated from the density.

$$\rho = A \div (A - B) \times (\rho_0 - \rho_L) + \rho_L \quad (4)$$

wherein:

$\rho$: the density of the sample (composite);
A: the weight of the sample measured in air;
B: the weight of the sample measured in displacement liquid (water);
$\rho_0$: the density of the substitution liquid (water) (1.0000 g/cm3); and
$\rho_L$: the density of air (0.0012 g/cm$^3$).

The results of the measured thermal diffusivity, specific heat and density were substituted into the following equation (5) to determine the thermal conductivity.

$$\text{Thermal conductivity = thermal diffusivity} \times$$

$$\text{specific heat} \times \text{density} \quad (5)$$

Table 5 shows these measurement results and calculation results.

[Table 5]

| Composite (resin + alumina particles) | Blend ratio (% by volume) Resin: Alumina particles | Thermal diffusivity | Specific heat (kJ/kg · K) | Specific gravity of composite | Thermal conductivity | |
|---|---|---|---|---|---|---|
| | | Measurement value (m$^2$/s) | | | Calculation value (W/mK) | Normalization |
| Epoxy resin + Raw material 1 | 61.8 : 38.2 | 5.75E-07 | 0.978 | 2.20 | 1.24 | 1 |
| Epoxy resin + Sample No. 1 | 64.6 : 35.4 | 7.03E-07 | 0.985 | 2.12 | 1.47 | 1.19 |
| Epoxy resin + Sample No. 2 | 58.6 : 41.4 | 5.04E-07 | 0.952 | 2.29 | 1.10 | 0.89 |
| Epoxy resin + Sample No. 3 | 58.1:41.9 | 1.01E-06 | 0.965 | 2.29 | 2.22 | 1.79 ' |
| Epoxy resin + Sample No. 4 | 55.7:44.3 | 8.79E-07 | 0.958 | 2.36 | 1.99 | 1.60 |
| Epoxy resin + Sample No. 5 | 53.6:46.4 | 1.11E-06 | 0.951 | 2.42 | 3.56 | 2.06 |

(continued)

| Composite (resin + alumina particles) | Blend ratio (% by volume) Resin: Alumina particles | Thermal diffusivity Measurement value (m²/s) | Specific heat (kJ/kg · K) | Specific gravity of composite | Thermal conductivity | |
|---|---|---|---|---|---|---|
| | | | | | Calculation value (W/mK) | Normalization |
| Epoxy resin + Sample No. 6 | 51.1:48.9 | 9.86E-07 | 0.943 | 2.51 | 2.33 | 1.88 |
| Epoxy resin alone | - | 1.12E-07 | 1.100 | 1.12 | 0.15 | - |

The measurement results will be discussed below.

The composites, prepared using the alumina particles of each of Sample Nos. 1 and 3 to 6, which satisfied the requirements of the embodiment of the present application, exhibited excellent thermal properties (thermal diffusivity and thermal conductivity). In contrast, the composite, prepared using the alumina particles of Sample No. 2, which did not satisfy the requirements of the embodiments of the present application, had poor thermal properties.

(7) Thermal diffusivity and thermal conductivity of alumina particles

The thermal diffusivity and thermal conductivity were further measured for one alumina particle of each of Sample Nos. 1 and 3 to 5. In the Examples in the present description, the thermal diffusivity of one alumina particle was successfully measured.

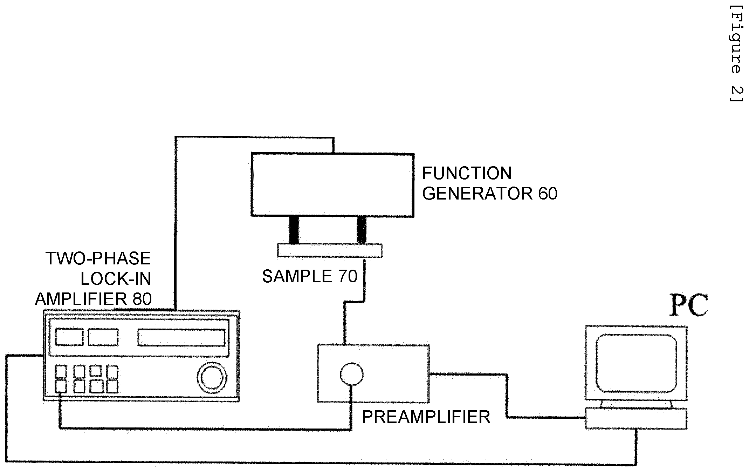

The method for measuring the thermal diffusivity of one alumina particle is the temperature wave thermal analysis method (TWA method) applied to a microscale measurement. Figure 2 shows a conceptual diagram of a device for measuring the thermal diffusivity of one alumina particle.

A thermoelectric microsensor was crimped to Sample 70 (one alumina particle). The frequency dependence of the phase difference due to the propagation of the temperature wave generated from a function generator by the alternating current heating of a resistance type microheater was measured by a two-phase lock-in amplifier 80 to determine the thermal diffusivity. The diameter of the sample 70 was about 110 $\mu$m, the thickness of the sample 70 was 67 $\mu$m, the measurement frequency was 2.7 kHz to 4.9 kHz, and the sensor size was 8 $\mu$m $\times$ 9 $\mu$m.

The thermal conductivity was calculated from the measurement value of the thermal diffusivity by the following equation (5). The specific heat was 0.779 kJ/kg·K, and the density used was the value shown in Table 4.

$$\texttt{Thermal conductivity = thermal diffusivity} \times$$

$$\texttt{specific heat} \times \texttt{density} \quad (5)$$

Table 6 shows these measurement results and calculation results.

[Table 6]

| | Sample No. | Thermal diffusivity of one particle (m²/s) | Thermal conductivity of one particle (W/mK) |
|---|---|---|---|
| Example | 1 | 1.05E-05 | 32.06 |
| Example | 3 | 1. 12E-05 | 34.20 |
| Example | 4 | 1.21E-05 | 36.90 |
| Example | 5 | 1.13E-05 | 34.50 |

The alumina particle of each of Sample Nos. 1 and 3 to 5 exhibited the values of the thermal diffusivity and thermal conductivity comparable to those measured for a bulk of a monocrystalline $\alpha$-alumina. The thermal conductivity of a polycrystalline $\alpha$-alumina particle measured in a preliminary experiment was 15 W/mK. It was found that the monocrystalline $\alpha$-alumina particle had about twice the thermal conductivity of polycrystalline $\alpha$-alumina particle.

(8) Measurement of intraparticle defect rate

The intraparticle defect rate was measured for alumina particles of each of Sample Nos. 1 to 4 and 6.

The alumina particles as being thinly dispersed on a substrate were subjected to X-ray transmission imaging in an area of 0.7 mm × 0.7 mm with a high-resolution X-ray CT scanner available from Rigaku Corporation (product name: nano3DX). Each of all 20 or more alumina particles in the acquired X-ray transmission image was subjected to confirmation of the particle defect. The particle defect means a void or an amorphous layer present inside a particle, and it is observed as a light gray portion within a defect-free portion (non-defective portion: observed as a white portion) of an alumina particle in an X-ray transmission image of the alumina particle.

The area SA of the entire alumina particle, the area SB of non-defective portions within the alumina particle, and the area SC of defective portions within the alumina particle were determined by subjecting the X-ray radiograph to image processing with an image processing software Image J (available from the National Institute of Health). The areas SA, SB and SC satisfies the equation SA = SB + SC.

SC/SA was expressed as a percentage and was defined as an intraparticle defect rate (%).

An image processing method for determining the areas SA, SB and SC will be described below.

The image of one alumina particle containing voids was cut out from the image acquired by the X-ray radiography and binarized with the image processing software "Image J", and was subjected to analysis of "Analyze Particles" to determine the area SA of the entire alumina particle. In the image acquired by X-ray radiography, the non-defective portions of the alumina particle have the lowest brightness, the defective portions within the particle have higher brightness than that, and the surrounding (background) portion of the alumina particle has the highest brightness. Accordingly, before the binarization processing, the image processing is required for converting the brightness of the defective portions and the background to the same degree as each other. Such image processing was performed by adjusting the contrast and adjusting the filter "Convolve". As a result, the area in the range left after cutting out the light gray portions, which are the defective portions, from the alumina particle (that is, the area SB of the non-defective portions) was measured.

In the particle analysis command, the area SA, where both the non-defective portions (area SB) and the defective portions (area SC) were included, inside the alumina particle (with the "Include holes" check turned on), and the area, where the defective portion was not included, inside the alumina particle (that is, the area SB of the non-defective portions) (with the "Include holes check" turned off) were measured. The area SC (=SA-SB) was calculated from the obtained areas SA and SB.

A lower intraparticle defect rate (SC/SA) means fewer voids or amorphous layers inside an alumina particle. Therefore, the intraparticle defect rate of the alumina particle is preferably low, particularly preferably 20% or less, and more preferably 15% or less. The use of such an alumina particle as a filler as resin compositions can further reduce the dielectric loss of the resin composition.

Table 7 shows the calculation results.

[Table 7]

|  | Sample No. | Intraparticle defect rate (%) |
|---|---|---|
| Example | 1 | 2.1 |
| Comparative Example | 2 | 230 |
| Example | 3 | 12.4 |
| Example | 4 | 3.7 |
| Example | 6 | 135 |

(9) Measurement of aspect ratio of impurity particle

The alumina particles of each of Sample Nos. 1 to 6 were subjected to X-ray transmission imaging in an area of 0.7 mm × 0.7 mm with a high-resolution X-ray CT scanner available from Rigaku Corporation (product name: nano3DX) .

The alumina particles to be evaluated with an image processing software Image J (available from the National Institute of Health) were all the alumina particles in the X-ray transmission image, and the aspect ratios of all the alumina particles to be evaluated were determined. The aspect ratio was calculated as the ratio of the maximum diameter of an alumina particle to the minimum diameter of the alumina particle which is a particle diameter in the direction perpendicular to the maximum diameter.

Impurity particles contained in the alumina particles to be evaluated were defined as alumina particles ranked in the top 1% in descending order of aspect ratio extracted from the alumina particles to be evaluated. The average value of the aspect ratios of the impurity particles was calculated.

The average aspect ratio of the impurity particles is preferably more than 1.2 and 5.0 or less, and particularly preferably 3 or less or 2.5 or less. The inclusion of a small amount of such impurity particles (elongated particles having a high aspect ratio) in the alumina particles can improve the filling rate of the alumina particles and can further reduce the dielectric loss of the resin composition, when the alumina particles is used as a filler for resin compositions.

Table 8 shows the measurement results.

[Table 8]

|  | Sample No. | Average aspect ratio of impurity particles |
|---|---|---|
| Example | 1 | 1.9 |
| Comparative Example | 2 | 1.2 |
| Example | 3 | 1.5 |
| Example | 4 | 2.4 |
| Example | 5 | 1.4 |
| Example | 6 | 1.9 |

(10) Measurement of the length L1 of the outer edge of the alumina particle and the total length L2 of the boundary lines inside the alumina particle

A sample for observing a cross-section was prepared with alumina particles of each of Sample Nos. 1 to 6. In preparing the sample for observing a cross-section, the alumina particles were embedded in a resin and, and the resin and the alumina particles were then cut with a diamond cutter. Thereafter, Pt was vapor-deposited on the cross-section as a protective film, and the cross-section was prepared by an Ar ion milling. It was fixed to a SEM sample stage with a Cu double-sided tape, and was subjected to EBSD measurement without vapor deposition. The observation position was determined so that two or more alumina particles were completely contained in the observation area (that is, two or more alumina particles did not come into contact with the frame of the observation area). Measurements were made for $\alpha$-alumina particles.

The following devices were used for the pretreatment and EBSD measurement of the samples.

- Device to be used

    Ion milling device: IM-4000 (available from Hitachi, Ltd.)
    Ion sputtering device: E-1030 (available from Hitachi, Ltd.)
    Ultra-high resolution field emission scanning electron microscope: JSM-7800F Prime (available from JEOL Ltd.)
    Electron backscatter diffraction device: Digiview V (available from TSL Solutions)

The conditions for EBSD measurement were as follows.

- Measurement area: 500.0 $\mu$m $\times$ 400.0 $\mu$m
- Accelerating voltage: 20.0 kV
- Magnification: $\times$ 500
- Low degree of vacuum: 30 Pa

Two or more alumina particles that are not in contact with the frame of the observation area are selected in the acquired EBSD image, and the outer edge length L1 of each alumina particle was measured and the average value was calculated with an image processing software Image J (available from the National Institute of Health). The total length L2 of the boundary lines was also calculated. The "total length L2 of the boundary lines" is the sum of the boundary lines included inside the alumina particle and does not include the outer edges of the alumina particle. The total length L2 of the boundary lines was calculated by adding the total length of the grain boundaries inside the alumina particle and (if voids are included inside the alumina particle) the total length of the inner walls of the voids.

The ratio (L2/L1) of the total length L2 of the boundary lines inside the alumina particle to the length L1 of the outer edge of the alumina particle was expressed as a percentage (%). When the alumina particle has more grain boundaries and voids inside thereof, the dielectric loss of the alumina particle is higher.

When the alumina particle has fewer grain boundaries and voids inside thereof, the dielectric loss of the alumina particles is lower. That is, when the ratio L2/L1 is smaller, the alumina particle has a lower dielectric loss. In particular, the alumina particle having a ratio L2/L1 of 100% or less are preferred and can further reduce the dielectric loss of the resin composition when used as a filler for resin compositions. The ratio (L2/L1) is more preferably 80% or less, even more preferably 50% or less, and particularly preferably 40% or less.

From the observation results of the inside of the particles, the particle of the Comparative Example had a void of about several tens of $\mu$m, and fine voids of several $\mu$m as well as grain boundaries were also observed. The particles of each of Examples had fine voids of several $\mu$m.

Table 9 shows the measurement results.

[Table 9]

|  | Sample No. | L2/L1 (%) |
|---|---|---|
| Example | 1 | 44 |
| Comparative Example | 2 | 102 |
| Example | 3 | 14 |
| Example | 4 | 31 |
| Example | 5 | 13 |
| Example | 6 | 23 |

(11) Measurement of the number of contact points between alumina particles in the resin composition (composite)

A polyimide resin (Varnish A available from UBE Corporation) and alumina particles of each of Sample Nos. 2 to 5 were mixed at a blend ratio of 20:80 by volume %. A film was prepared from the mixture with a bar coater, and the film was baked in an $N_2$ atmosphere to prepare an alumina-resin composite. A cross section along the thickness direction of the composite was exposed by an Ar ion milling, and the cross section was observed.

The following equipment and conditions were used to cut the cross-section out and to observe the cross-section.

- Cutting a cross-section out: preparation of a cross section with a milling device
  Device: E-3500 (available from Hitachi, Ltd.)
- Observation of a cross-section: observation with a laser microscope (LSM; Laser Scanning Microscopy)

  Device: OLS4000 (available from Olympus Corporation)
  Measurement mode: magnification 20x
  Resolution: $1024 \times 1942$
  Measurement range: about 650 $\mu$m in x direction $\times$ about 750 $\mu$m in y direction

The number of contact points between alumina particles in the resin composition was determined from each cross-sectional LSM image. The alumina particles are observed as gray and the resin as white in the cross-sectional LSM image. The number of points shown in gray in which the alumina particles are in direct contact with each other was counted as the number of contact points between alumina particles.

The number of contact points can serve as an index of the dispersity of particles, and the number of contact points between alumina particles are reduced when the alumina particles are uniformly dispersed.

An increase in the number of contact points between adjacent alumina particles (that is, the number of interfaces between particles) in a resin composition results in an increase in the dielectric loss of the resin composition.

The number of contact points between alumina particles is preferably 40 or less in an observation range of 650 $\mu$m $\times$ 750 $\mu$m (equivalent to 82 or less per mm of an observation range). In such a case, the dielectric loss of the resin composition can be further reduced when the alumina particles are used as a filler for resin compositions.

The number of contact points between alumina particles is more preferably 65/mm$^2$ or less, particularly preferably 50/mm$^2$ or less or 30/mm$^2$ or less in terms of the number of contact points in an observation range of 1 mm$^2$.

Table 10 shows the measurement results.

[Table 10]

| | Sample No. | Number of contact points | |
|---|---|---|---|
| | | Number in observation **range of 650μm×750μm** (count) | Number per mm² of observation range (count/mm²) |
| Comparative Example | 2 | 34 | 70 |
| Example | 3 | 12 | 25 |
| Example | 4 | 7 | 14 |
| Example | 5 | 7 | 14 |

(12) Measurement of BET specific surface area of alumina particle

The BET specific surface area of the alumina particle of each of Sample Nos. 1 to 6 was measured.

The measurement was performed by a method for measuring the specific surface area of powder (solid) by gas adsorption in accordance with JIS Z 8830:2013 and using Kr as an adsorbed gas. In the measurement, 1 g of alumina particles was put into a sample tube to obtain an adsorption/desorption isotherm, and a Kr-BET specific surface area S1 ($m^2/g$) was calculated by a multi-point plot method.

The ratio (S1/S2) of the Kr-BET specific surface area S1 ($m^2/g$) to the ideal spherical area S2 ($\mu m^2$) determined from D50 was also calculated. The ideal spherical area refers to the surface area of a perfectly spherical particle having a particle diameter equivalent to a D50, and was calculated from the formula for the surface area of a sphere ($4\pi r^2$) .

When the alumina particle has few irregularities on the particle surface, the interface between the alumina particle and a resin is reduced, so that the dielectric loss of the resin composition can be reduced when used as a filler for resin compositions. Both the BET specific surface area and the ratio (S1/S2) of the Kr-BET specific surface area to the ideal spherical area serve as indexes of the degree of irregularities of the particles.

The alumina particles having a BET specific surface area S1 by the Kr adsorption method of 0.10 $m^2/g$ or less are preferred, and can further reduce the dielectric loss of the resin composition when used as a filler for resin compositions. The Kr-BET specific surface area S1 is more preferably 0.08 $m^2/g$ or less, and particularly preferably 0.07 $m^2/g$ or less.

The Kr-BET specific surface area S1 may be 0.01 $m^2/g$ or more, or may be 0.02 $m^2/g$ or more.

The alumina particle having a ratio (S1/S2) of the Kr-BET specific surface area to the ideal spherical area of $95 \times 10^5/g$ or less is preferred, and can further reduce the dielectric loss of the resin composition when used as a filler for resin compositions. The ratio (S1/S2) is more preferably $40 \times 10^5/g$ or less, and particularly preferably $20 \times 10^5/g$ or less.

Table 11 shows the measurement results and calculation results.

[Table 11]

| | Sample No. | Kr-BET specific surface area S1 ($m^2/g$) | Particle diameter D50 ($\mu m$) | Ideal spherical area S2 ($m^2$) | S1/S2 (/g) |
|---|---|---|---|---|---|
| Example | 1 | 0.068 | 112 | $3.9388\times10^{-8}$ | $17\times10^5$ |
| Comparative Example | 2 | 0.126 | 63 | $1.2463\times10^{-8}$ | $101\times10^5$ |
| Example | 3 | 0.066 | 123 | $4.7505\times10^{-8}$ | $14\times10^5$ |
| Example | 4 | 0.058 | 125 | $4.9063\times10^{-8}$ | $12\times10^5$ |
| Example | 5 | 0.053 | 136 | $5.8077\times10^{-8}$ | $91\times10^5$ |
| Example | 6 | 0.067 | 116 | $4.2252\times10^{-8}$ | $16\times10^5$ |

(13) Measurement of content of bring-in moisture by alumina particles and resin)

The content of bring-in moisture by alumina particles of each of Sample Nos 2, 3, 5 and 6 was determined as follows. A 1 g portion of alumina particles was previously weighed out and left in air for 24 hours, and the mass thereof was then measured as a pre-measurement mass Ma1 (g). Thereafter, the alumina particles were dried in a vacuum dryer for 24 hours, and the mass thereof was then measured as a post-measurement mass Ma2 (g). (Pre-measurement mass Ma1 - post-measurement mass Ma2)/(pre-measurement mass Ma1) $\times$ $10^6$ was defined as a content of bring-in moisture by the alumina particles $\Delta$Ma (ppm).

The content of bring-in moisture by the resin was determined as follows.

A film was prepared from a polyimide resin (Varnish A available from UBE Corporation) with a bar coater, and the film was baked in an $N_2$ atmosphere to prepare a resin film having a thickness of about 300 $\mu$m. A sample piece of 1 cm $\times$ 1 cm was cut out from the resin film. The sample piece was left in air for 24 hours, and the mass thereof was then measured as a pre-measurement mass Mr1 (g). Thereafter, the polyimide resin was dried in a vacuum dryer for 24 hours, and the mass thereof was then measured as a post-measurement mass Mr2 (g). (Pre-measurement mass Mr1 - post-measurement mass Mr2)/(pre-measurement mass Mr1) $\times$ $10^6$ was defined as a content of bring-in moisture by the polyimide resin $\Delta$Mr (ppm).

A ratio ($\Delta$Ma/$\Delta$Mr) of the content of bring-in moisture $\Delta$Ma by the alumina particles to the content of bring-in moisture $\Delta$Mr (ppm) by the polyimide resin was calculated. The ratio $\Delta$Ma/$\Delta$Mr is preferably 0.2 or less, and more preferably 0.1 or less. Since the content of bring-in moisture $\Delta$Ma by the alumina particles is extremely small compared to the content of bring-in moisture by the resin, the dielectric loss of the resin composition can be further reduced when the alumina particles are used as a filler for resin compositions.

Table 12 shows the calculation results.

[Table 12]

|  | Sample No. | Content of bring-in moisture by alumina particles $\Delta$**Ma(ppm)** | $\Delta$**Ma/**$\Delta$**Mr** |
|---|---|---|---|
| Comparative Example | 2 | 1100 | 0.244 |
| Example | 3 | 270 | 0.060 |
| Example | 5 | 300 | 0.067 |
| Example | 6 | 260 | 0.058 |

(14) Measurement of dielectric loss of resin composition (composite)

A polyimide resin (Varnish A available from UBE Corporation) and alumina particles of each of Sample Nos. 1 to 6 were mixed at a blend ratio of 20:80 by volume %. A film was prepared from the mixture with a bar coater, and the film was baked in an $N_2$ atmosphere to prepare an alumina-resin composite having a thickness of 800 $\mu$m.

The dielectric loss of the composite was measured under the following measurement conditions.

- Measurement device: a network analyzer HP8510C (available from Agilent Technologies)
- Sweep signal generator: HP83651A, t HP8517B (both available from Agilent Technologies)
- Size of test piece: 110 mm $\times$ 60 mm
- Measurement frequency: 10 GHz
- Test environment: 22°C/59% RH

Table 13 shows the measurement results.

[Table 13]

|  | Sample No. | Dielectric loss |
|---|---|---|
| Example | 1 | 0.0032 |
| Comparative Example | 2 | 0.0049 |
| Example | 3 | 0.0029 |
| Example | 4 | 0.0027 |
| Example | 5 | 0.0028 |
| Example | 6 | 0.0029 |

The composites of Sample Nos. 1 and 3 to 6 had a low dielectric loss and the composite of Sample No. 2 had a high dielectric loss.

(15) Measurement of pore volume of alumina particle

The pore volume of the alumina particle of each of Sample Nos. 1 to 6 was measured.

The measurement was performed by a method for measuring the specific surface area of powder (solid) by gas adsorption in accordance with JIS Z 8830:2013 and using Kr as an adsorbed gas. In the measurement, 1 g of alumina particles was put into a sample tube to obtain an adsorption/desorption isotherm, and pore volume distribution analysis was performed by a multipoint plot method to obtain a pore volume.

The pore volume of the alumina particle is preferably 0.0003 $cm^3$/g or less as measured by the krypton adsorption method.

Similar to the Kr-BET specific surface area, the pore volume serves as an index for recognizing the degree of irregularities on the particle surface. Controlling the pore volume of the first alumina particle to the above range can further improve the moldability of a mixture.

The pore volume is more preferably 0.00009 $cm^3$/g or less, and particularly preferably 0.00007 $cm^3$/g or less. The lower limit of the pore volume is not limited, but it may be, for example, 0.000001 $cm^3$/g or more, or even 0.000005 $cm^3$/g or more.

Table 14 shows the measurement results.

[Table 14]

|  | Sample No. | Pore volume ($cm^3$/g) |
|---|---|---|
| Example | 1 | 0.00006 |
| Comparative Example | 2 | 0.00038 |
| Example | 3 | 0.00008 |
| Example | 4 | 0.00004 |
| Example | 5 | 0.00004 |
| Example | 6 | 0.00022 |

[Reference Signs List]

10   Oxygen gas feed system
11   Carrier oxygen gas
12   Oxygen gas for combustion
20   Fuel gas feed system
30   Feeder
40   Flame fusion furnace
50   Cyclone
60   Function generator
70   Sample
80   Two-phase lock-in amplifier

**Claims**

1. An alumina particle having a particle diameter D50 of more than 100 $\mu$m at a cumulative value of 50% from the fine particle side in the cumulative particle size distribution, and having an $\alpha$-alumina rate of 90% or more; wherein the $\alpha$-alumina is a monocrystalline alumina.

2. The alumina particle according to claim 1 having a Na content of 800 ppm or less.

3. The alumina particle according to claim 1 having a particle diameter D10 of 70 to 135 $\mu$m at a cumulative value of 10% from the fine particle side in the cumulative particle size distribution.

4. The alumina particle according to claim 1 having a particle diameter D90 of 130 to 200 $\mu$m at a cumulative value of 90% from the fine particle side in the cumulative particle size distribution.

5. The alumina particle according to claim 1 having a circularity of 0.90 to 1.00.

6. The alumina particle according to claim 1 having a density of 3.80 g/cm$^3$ or more.

7. A resin composition comprising a resin and the alumina particle according to any one of claims 1 to 6.

[Figure 1]

[Figure 2]

[Figure 3]

$$S A = S B + S C$$

PARTICLE DEFECT RATE (%) $= S C / S A \times 1 0 0$

## INTERNATIONAL SEARCH REPORT

| International application No. |
| --- |
| **PCT/JP2022/021614** |

| A. | CLASSIFICATION OF SUBJECT MATTER |
| --- | --- |

***C01F 7/02***(2022.01)i; ***C01F 7/022***(2022.01)i; ***C01F 7/027***(2022.01)i; ***C08K 3/22***(2006.01)i; ***C08L 101/00***(2006.01)i
FI: C01F7/02; C01F7/022; C01F7/027; C08K3/22; C08L101/00

According to International Patent Classification (IPC) or to both national classification and IPC

| B. | FIELDS SEARCHED |
| --- | --- |

Minimum documentation searched (classification system followed by classification symbols)

C01F7/02; C01F7/022; C01F7/027; C08K3/22; C08L101/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | WO 2008/053536 A1 (DENKI KAGAKU KOGYO KK) 08 May 2008 (2008-05-08) claims 1, 9, paragraphs [0009], [0010], [0013] | 1-7 |
| Y | WO 2020/153505 A1 (DENKA CO., LTD.) 30 July 2020 (2020-07-30) claims 1, 5-6, paragraph [0023] | 1-7 |
| Y | JP 2012-067205 A (HITACHI KASEI KOGYO KK) 05 April 2012 (2012-04-05) claim 1, paragraphs [0031]-[0033] | 1-7 |
| Y | JP 2015-078306 A (OSAKA GAS CO., LTD.) 23 April 2015 (2015-04-23) claim 1, paragraph [0007] | 1-7 |
| Y | WO 2009/017170 A1 (DENKI KAGAKU KOGYO KK) 05 February 2009 (2009-02-05) claims 1, 8, paragraph [0012] | 2 |
| Y | JP 2015-166294 A (NIPPON LIGHT METAL CO., LTD.) 24 September 2015 (2015-09-24) claim 1, paragraphs [0003], [0017] | 2 |
| Y | JP 2019-167283 A (KAWAI LIME INDUSTRY CO., LTD.) 03 October 2019 (2019-10-03) claims 1-2, paragraphs [0011], [0014] | 6 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **06 July 2022** | **26 July 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2022/021614**

| C. | DOCUMENTS CONSIDERED TO BE RELEVANT | |
|---|---|---|
| Category* | Citation of document, with indication, where appropriate, of the relevant passages | Relevant to claim No. |
| A | WO 2020/170307 A1 (ADMATECHS CO., LTD.) 27 August 2020 (2020-08-27)<br>entire text | 1-7 |

Form PCT/ISA/210 (second sheet) (January 2015)

## INTERNATIONAL SEARCH REPORT
### Information on patent family members

International application No.

**PCT/JP2022/021614**

| Patent document cited in search report | | | Publication date (day/month/year) | Patent family member(s) | | | Publication date (day/month/year) |
|---|---|---|---|---|---|---|---|
| WO | 2008/053536 | A1 | 08 May 2008 | US | 2010/0051855 | A1 | |
| | | | | claims 1, 9, paragraphs [0016], [0017], [0022] | | | |
| | | | | CN | 101528604 | A | |
| WO | 2020/153505 | A1 | 30 July 2020 | EP | 3915939 | A1 | |
| | | | | claims 1, 5-6, paragraph [0023] | | | |
| | | | | CN | 113329973 | A | |
| | | | | KR | 10-2021-0121023 | A | |
| JP | 2012-067205 | A | 05 April 2012 | (Family: none) | | | |
| JP | 2015-078306 | A | 23 April 2015 | (Family: none) | | | |
| WO | 2009/017170 | A1 | 05 February 2009 | (Family: none) | | | |
| JP | 2015-166294 | A | 24 September 2015 | CN | 106103347 | A | |
| | | | | claim 1, paragraphs [0003], [0027] | | | |
| | | | | WO | 2015/133191 | A1 | |
| JP | 2019-167283 | A | 03 October 2019 | (Family: none) | | | |
| WO | 2020/170307 | A1 | 27 August 2020 | US | 2020/0263071 | A1 | |
| | | | | entire text | | | |
| | | | | EP | 3882215 | A1 | |
| | | | | CN | 111836780 | A | |
| | | | | JP | 6561220 | B1 | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009133904 A
- WO 2008053536 A
- JP 2006169090 A